# EUROPÄISCHE PATENTANMELDUNG

(11) **EP 4 811 023 A1**
(43) Veröffentlichungstag der Anmeldung: **23.09.2026**
(21) Anmeldenummer: 26162575.0
(22) Anmeldetag: 05.03.2026
(51) Int. Cl.: G02F 1/025, H04B 10/50

(54) **OPTOELEKTRONISCHE SENDEVORRICHTUNG**

(30) Priorität: 18.03.2025 AT 501742025
(71) Anmelder: AIT Austrian Institute of Technology GmbH, 1210 Wien (AT)
(72) Erfinder: Schrenk, Bernhard, 2122 Ulrichskirchen (AT)
(74) Vertreter: Wildhack & Jellinek Patentanwälte GmbH

(57) **Zusammenfassung**

Optoelektronische Sendevorrichtung (T1; T2) und Verfahren umfassend einen Wellenleiter (C), in dem eine Licht emittierende, insbesondere Silizium-Germanium, PIN-Diode (D) angeordnet ist, die dazu ausgebildet ist, Licht nach beiden Richtungen des Wellenleiters (C), dh in einen ersten Wellenleiterausgang (O1) und einen zweiten Wellenleiterausgang (O2) abzustrahlen, wobei eine optische Mischvorrichtung (M; R) vorgesehen ist, die optisch an die beiden Wellenleiterausgänge (O1, O2) des Wellenleiters (C) angekoppelt ist und in der sich das durch diese Wellenleiterausgänge (O1, O2) transportierte Licht (LO1; LO2) überlagert, wobei im Signalweg des Lichts zwischen zumindest einem Wellenleiterausgang (O1, O2) und der optischen Mischvorrichtung (M; R), insbesondere jeweils separat im jeweiligen Signalweg des Lichts zwischen jedem der beiden Wellenleiterausgänge (O1, O2) und der optischen Mischvorrichtung (M; R), ein Phasenschieber (P1; P2) angeordnet ist, der abhängig von einem elektrischen Stellsignal (eS1; eS2) die Phase des durch den jeweiligen Wellenleiterausgang (O1, O2) transportierten Lichts (LO1; LO2) verschiebt.

## Beschreibung

Die Erfindung betrifft eine optoelektronische Sendevorrichtung nach Anspruch 1 sowie ein Verfahren zur Ankopplung eines Ausgangs-Wellenleiters an den optischen Ausgang einer optischen Sendevorrichtung nach Anspruch 10.

Aus dem Stand der Technik sind Lichtemitter basierend auf III-V Materialien bekannt. Diese sind auch effizient, d.h. das Verhältnis von emittierter Lichtleistung zu injiziertem elektrischem Strom ist sehr gut. Zudem kann die Wellenlänge durch das Design gewählt werden. Der Bereich deckt sowohl den sichtbaren Wellenlängenbereich als auch das nahe Infrarot (Telekom-Fenster um die 1550 nm) gut ab.

Soll nun ein solcher III-V Lichtemitter (z.B. basierend auf InP, InGaAs), der auf einem Halbleitermaterial mit direktem Bandgap beruht, mit kostengünstigen Silizium-basierten Modulatoren, Detektoren bzw. anderen (wellenleitergebundenen) Elementen zur Signalmanipulation kombiniert werden, so ist dies mit einem enormen Aufwand in Bezug auf Hetero-Integration sowie auch in Bezug auf Assembly und Packaging verbunden, was die Kosten einer derart hybriden Komponente signifikant steigert. Eine monolithisch integrierte Komponente auf Silizium-Basis (Gruppe IV im Periodensystem) würde diesbezüglich einen klaren Vorteil bringen, es wären beispielsweise weniger Interfaces zwischen Chips erforderlich, da nur ein Chip notwendig wäre und damit auch das Alignment zwischen optischen Wellenleitern unterschiedlicher Chips entfiele, um eine gute optische Kopplung zu erreichen. Ebenso können die Kosten für das Packaging entfallen, da Silizium-basierte Elemente nicht zwingend hermetisch versiegelt werden müssen, um deren Lebensdauer zu garantieren.

Silizium als Halbleitermaterial eignet sich dagegen weniger gut für die Herstellung von Lichtemittem, da es ein indirektes Bandgap aufweist, was die Effizienz der Lichtemission stark, dh um mehrere Zehnerpotenzen im Vergleich mit direkten Halbleitern reduziert. Ein Ansatz, der bekannt ist, um Silizium-Leuchtdioden zu realisieren, ist die Verwendung von Germanium - einem Material, welches mit Silizium-Integrationsplattformen kompatibel ist. Germanium hat ein pseudo-direktes Bandgap, dessen direktes Minimum im Banddiagrarrm ("┌ Valley") energetisch gesehen nur knapp über dem indirekten Minimum ("L Valley") liegt. Die Bandstruktur eines Halbleiters korreliert mit der Gitterkonstante, welche durch Verspannung modifiziert werden kann. Durch eine solche Verspannung im Halbleiter ("tensile stress") kann dieser Unterschied im Minimum des Banddiagramms verringert werden, wodurch sich die Emissionseffizienz erhöht. Diese Germanium-LEDs wurden in Hinsicht auf im Vergleich zu rein Silizium-basierten LEDs auf ihre erhöhte Effizienz im Telekom-Fenster gezeigt. Allerdings handelt es sich bei diesen Germanium-LEDs um sehr spezielle und aufwendig zu fertigende Bauelemente, die unter anderem sehr spezielle und kostenaufwendige Fertigungsschritte benötigen.

Im Zuge der gegenständlichen Erfindung werden hingegen einfachere Silizium-Germanium Elemente basierend auf einem simplifizierten Aufbau einer PIN-Diode eingesetzt, um diese Lichtemission bei Raumtemperatur zu erzielen. Zur Verwendung einer solchen optischaktiven PIN-Diode als Lichtemitter für einen integrierten Schaltkreis zur Signalmodulation wird diese in Vorwärtsrichtung betrieben.

Aufgabe der Erfindung ist es, eine Sendevonichtung zur Verfügung zu stellen, die unmittelbar in einem Silizium-Chip integriert werden kann. Die Erfindung löst diese Aufgabe bei einer optoelektronischen Sendevorrichtung umfassend einen Wellenleiter, in dem eine Licht emittierende, insbesondere Silizium-Germanium, PIN-Diode angeordnet ist, die dazu ausgebildet ist, Licht nach beiden Richtungen des Wellenleiters, dh in einen ersten Wellenleiterausgang und einen zweiten Wellenleiterausgang abzustrahlen,
wobei eine optische Mischvorrichtung vorgesehen ist, die optisch an die beiden Wellenleiterausgänge des Wellenleiters angekoppelt ist und in der sich das durch diese Wellenleiterausgänge transportierte Licht überlagert,
wobei im Signalweg des Lichts zwischen zumindest einem Wellenleiterausgang und der optischen Mischvorrichtung, insbesondere jeweils separat im jeweiligen Signalweg des Lichts zwischen jedem der beiden Wellenleiterausgänge und der optischen Mischvorrichtung, ein Phasenschieber angeordnet ist, der abhängig von einem elektrischen Stellsignal die Phase des durch den jeweiligen Wellenleiterausgang transportierten Lichts verschiebt,
wobei die Mischvorrichtung zwei optische Ausgänge aufweist, wobei die Intensität des an den optischen Ausgängen abgestrahlten Lichts jeweils vom Ergebnis der Überlagerung der beiden über die beiden Wellenleiterausgänge des ersten Wellenleiters zugeführten Lichtanteile abhängt, und
wobei eine Steuervorrichtung vorgesehen ist, die dem ersten oder zweiten Wellenleiterausgang nachgeordneten Phasenschieber, insbesondere beide den Wellenleiterausgängen nachgeordneten Phasenschieber, derart ansteuert, dass die jeweiligen Lichtintensitäten des Lichts an den beiden optischen Ausgängen der Mischvorrichtung in einem vorgegebenen Verhältnis eingestellt sind, insbesondere gleich sind,
wobei die beiden optischen Ausgänge der Mischvorrichtung über zwei weitere Wellenleiter an die beiden Wellenleiter-Anschlüsse eines polarisierenden Strahlteilers geführt sind, wobei in den beiden weitere Wellenleitern jeweils ein elektrisch gesteuerter Phasenmodulator angeordnet ist, der dazu ausgebildet ist, abhängig von dem ihm jeweils zugeführten elektrischen zu übertragenden Eingangssignal die Phasenlage des durch den jeweiligen weitere Wellenleiter geführten Lichts einzustellen, und
wobei der optische Ausgang des polarisierenden Strahlteilers den Ausgang der Sendevorrichtung bildet.

Eine bevorzugte Integration der optischen Sendevorrichtung in einen Silizium-Träger oder Silizlum-Chip sieht vor, dass der Wellenleiter und die weiteren Wellenleiter parallel zur Ebene des Silizium-Trägers angeordnet sind und dass die Abstrahlrichtung des polarisierenden Strahlteilers im Winkel, insbesondere normal, zur Ebene des Silizium-Trägers steht, und dass die PIN-Diode gegebenenfalls mit dotiertem Silizium gebildet und Im Sillzium-Träger integriert ist.

Eine vorteilhafte Ausprägung der Erfindung, die eine einfache Überlagerung des von der PIN-Diode erzeugten Lichts erlaubt, sieht vor, dass die Mischvorrichtung durch einen optischen Koppler (M), insbesondere einen 50/50 Koppler, mit vier optischen Anschlüssen ausgebildet ist, an dessen Eingängen die beiden Wellenleiterausgänge angekoppelt sind und an dessen optischen Ausgängen die beiden Wellenleiter angeschlossen sind.

Eine hierzu alternative Ausprägung der Erfindung, die neben der Überlagerung des von der PIN-Diode erzeugten Lichts auch eine Filterwirkung beim abgestrahlten Licht für bestimmte Frequenzen erzielt, sieht vor, dass die Mischvorrichtung durch einen Ringresonator ausgebildet ist, an den die beiden Wellenleiterausgänge über den Einkoppelwellenleiter des Ringresonators angekoppelt sind, wobei die beiden Wellenleiterausgänge aus demselben Wellenleiter gebildet sind und dieser Wellenleiter eine Ringschleife ausbildet und ein Teil dieser Ringschleife den Einkoppelwellenleiter des Ringresonators bildet, und an den die beiden weiteren Wellenleiter über den Auskoppelwellenleiter des Ringresonators angekoppelt sind und den Ausgang der Mischvorrichtung bilden.

Eine bevorzugte Ausführungsform der Erfindung, die eine Filterwirkung beim abgestrahlten Licht für bestimmte Frequenzen erzielt, sieht vor, dass die PIN-Diode einen aktiven lichterzeugenden Wellenleiterabschnitt umfasst, an den nach zumindest einer Seite, insbesondere nach beiden Seiten, zum jeweiligen Wellenleiterausgang hin, ein passiver Wellenleiterabschnitt anschließt, der eine Filterwirkung derart aufweist. dass der passive Wellenleiterabschnitt vorzugsweise nur für Licht innerhalb eines vorgegebenen Frequenzbands durchlässig ist.

Eine weitere bevorzugte Ausführungsform der Erfindung, die eine Filterwirkung beim abgestrahlten Licht für bestimmte Frequenzen erzielt, sieht vor, dass im Lichtweg, insbesondere im Wellenleiter der Kavität, im Mischer oder in den weiteren Wellenleitern jeweils Filterelemente vorgesehen sind, die dazu ausgebildet sind, einzelne Anteile des Lichts herauszufiltern.

Eine besondere Anpassung der Filterwirkung an das abgestrahlte Licht sieht vor, dass der Resonator und/oder der passive Wellenleiterabschnitt auf die PIN-Diode derart abgestimmt Ist, dass dieser für Frequenzantelle des von der PIN-Diode erstellten Lichts durchlässig Ist.

Zur Übertragung von Datensignalen oder Zufallssignalen kann vorgesehen sein, dass die elektrische Steuereinheit dazu ausgebildet ist,
a) einen zu übertragenden Datenstrom an einem Eingang zu erhalten und nach vorgegebenen Kriterien zu transformieren, oder mittels eines Zufallsgenerators einen zu übertragenden Datenstrom zu erstellen und
b) basierend auf diesem Datenstrom ein zu übertragendes Eingangssignal für die Phasenmodulatoren bereitzuhalten.

Eine besonders hohe Lichtausbeute lässt sich erzielen, wenn die Steuereinheit dazu ausgebildet ist, die PIN-Diode mit einem durch den zu übertragenden Datenstrom festgelegten oder vom zu übertragenden Datenstrom vorgegebenen Steuersignal anzusteuern, insbesondere derart, dass das Steuersignal sowie die zu übertragenden elektrischen Eingangssignal derart aufeinander abgestimmt sind, dass das Maximum der von der PIN-Diode abgegebenen Lichtpulse mit der zeitlichen Mitte eines Informationssymbols im Eingangssignal zeitlich übereinstimmt.

Weiters betrifft die Erfindung ein bevorzugtes Verfahren zur Ankopplung einer optischen Sendevorrichtung an einen Empfänger zum Empfang der vom optischen Ausgang ausgehenden Lichtsignale oder an einen Ausgangs-Wellenleiter an den optischen Ausgang, die mittels einer PIN-Diode erzeugtes Licht an ihrem Ausgang bereithält, der durch den optischen Ausgang eines polarisierenden Strahlteilers ausgebildet ist, wobei die optische Sendevorrichtung vorzugsweise nach einem der vorangehenden Ansprüche ausgebildet ist

Eine solche Ankopplung kann besonders einfach mit den folgenden Schritten erreicht werden:
a) Einstrahlen von Licht, insbesondere Laserlicht, vorzugsweise mit derselben Frequenz wie das von der Sendevorrichtung abgestrahlte Licht, in den optischen Ausgang der optischen Sendevorrichtung, insbesondere über den Ausgangs-Wellenleiter,
b) Ermitteln des dadurch an der PIN-Diode bewirkten Photostroms, welcher am elektrischen Anschluss der PIN-Diode bereitgestellt wird,
   unter Änderung der Relativposition und/oder -ausrichtung des Ausgangs-Wellenleiter oder des Empfängers relativ zum polarisierenden Strahlteiler, insbesondere des lateralen und vertikalen Abstands des Ausgangs-Wellenleiters des polarisierenden Strahlteiler zum Ausgangs-Wellenleiter, und dahingehend, dass sich der in Schritt b) ermittelte Photostrom erhöht oder dass dieser Photostrom maximiert wird.

Einzelne Ausführungsformen der Erfindung werden anhand der folgenden Zeichnungsfiguren näher beschrieben. In Fig. 1a und 1b sind einige Ausführungsformen mit typischen Strukturen von wellenleitergebundenen Silizium-Germanium PIN-Diode n näher dargestellt. Fig. 2 zeigt eine Schaltung mit einer Sendevorrichtung entsprechend einer ersten Ausführungsform der Erfindung, Fig. 3 zeigt eine Schaltung mit einer Sendevorrichtung entsprechend einer zweiten Ausführungsform der Erfindung mit einem Ringresonator als Mischer.

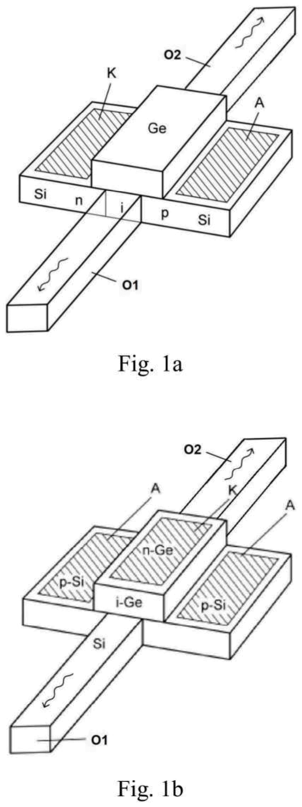

In Fig. 1a und 1b sind Strukturen von wellenleitergebundenen Silizium-Germanium PIN-Dioden D dargestellt. Die Parameter dieser PIN-Diode D werden in den Ausführungsformen zweckmäßigerweise für den Betrieb als Lichtemitter optimiert, ohne dabei den Fertigungsprozess maßgeblich zu beineinträchtigen, wie es z.B. für typische emissionsbegünstigende Mechanismen wie etwa das Einbringen von Quanten-Dots in die Struktur notwendig wäre.

Grundsätzlich sind aus der Literatur vertikale und laterale Strukturen für PIN-Dioden D bekannt. Diese sind im Stand der Technik bereits erprobt und zur Detektion von Licht unterschiedlicher Wellenlängen geeignet. Die Funktion und Herstellung solcher PIN-Dioden D ist beispielsweise in Siew et al, Review of Silicon Photonics Technology and Platform Development, JOURNAL OF LIGHTWAVE TECHNOLOGY, VOL. 39, NO. 13, Jul. 2021, Seiten 4374-4389 näher beschrieben. Für den Betrieb mit möglichst effizienter Lichtemission wird im Weiteren die Kopplung von Germanium in den Wellenleiter durch den geometrischen Aufbau und speziell die Dicke der i-Zone optimiert. Hierzu eignen sich Insbesondere laterale PIN-Strukturen. Zusätzlich ist für eine akzeptable Lichtleistung (von etwa 100 pW für das C-Band Spektrum) eine ausreichend lange lichtsensitive Zone bereitzustellen, welche in Vorwärtsrichtung die Lichtemission bewerkstelligt. Es ergibt sich daher, bezogen auf den exakten Aufbau der PIN-Dioden D und die für die Herstellung verwendete Silizium-basierte Integrationsplattform, In der Regel ein optimaler Wert für die Breite der i-Zone sowie für die Länge der lichtsensitiven Zone, um bei gleichem Vorwärtsstrom einen optimalen Arbeitspunkt zu gewährleisten.

Betreibt man die In den Fig. 1a und 1b dargestellten PIN-Dioden D in Vorwärtsrichtung, liefern diese an Ihren optischen Wellenleiterausgängen O1, O2 einen konstanten Licht-Output mit einer relativ breiten spektralen Charakteristik, ähnlich einer Leuchtdiode. Allerdings ist die Lichtleistung wesentlich geringer und beträgt typischerweise 100 pW bei einem Durchlassstrom von 20 mA. Diese Lichtleistung ist in der Regel nicht ausreichend, um Datenanwendungen im Telekom-Bereich zu ermöglichen, da die Empfindlichkeit von optoelektronischen Empfängern selbst beim Einsatz von zusätzlicher optischer Vorverstärkung nicht ausreicht. Das Halbleitermaterial kann durch bekannte Methoden so gestaltet sein, dass ein spezieller Wellenlängenbereich adressiert wird, wie etwa das Telekom Fenster mit C + L Band mit einer Wellenlänge zwischen 1530 bis 1625 nm - für beide Betriebsarten.

Diese optisch breitbandige Emission kann zwar der Etablierung des Wellenlängen-Multiplex dienen, indem ein schmäleres Fenster (von z.B. 1 nm Bandbreite) aus der breitbandigen Lichtemission bei einer gewünschten Mitten-Wellenlänge innerhalb der optischen Gesamt-Bandbreite extrahiert wird; Gleichzeitig kann ein zu breites Spektrum jedoch auch zu Performance-Einbußen führen, wenn diese breitbandige Lichtemission direkt für die Beaufschlagung mit Information im Zuge einer Lichtmodulation genutzt wird. Insbesondere ergibt sich bei Modulation der Lichtpolarisation der Effekt der Depolarisierung, wenn breitbandiges Licht über einen Glasfaserkanal übertragen wird. Dieser Effekt führt zu Fehlem bei der Demodulation der mittle Polarisationsmodulation aufgeprägten Information.

Die Ausbildung der PIN-Diode verfügt im vorliegenden Ausführungsbeispiel über zwei Wellenleiter, über die Licht LO1, LO2 abgegeben wird, wobei sich der lichtemittierende Teil der PIN-Diode D über den gesamten Wellenleiter erstreckt, dh die PIN-Diode verfügt über einen lichterzeugenden Wellenleiterabschnitts, dessen Enden die Wellenleiterausgänge O1, O2 bilden. Es ist aber auch möglich, dass die PIN-Diode D nur einen aktiven lichterzeugenden Wellenleiterabschnitt umfasst, an den nach beiden Seiten zum jeweiligen Wellenleiterausgang O1, O2 hin, ein passiver Wellenleiterabschnitt anschließt. Dieser kann eine Filterwirkung in einer Form aufweisen, dass der passive Wellenleiterabschnitt vorzugsweise nur für Licht innerhalb eines vorgegebenen Frequenzbands durchlässig ist. Alternativ dazu ist es auch möglich, dass nur an einen der beiden Enden des aktiven lichterzeugenden Wellenleiterabschnitts ein passiver Wellenleiterabschnitt mit der besagten Filterwirkung anschließt, während das andere Ende des lichterzeugenden Wellenleiterabschnitts unmittelbar den Wellenleiterausgang O1, O2 bildet.

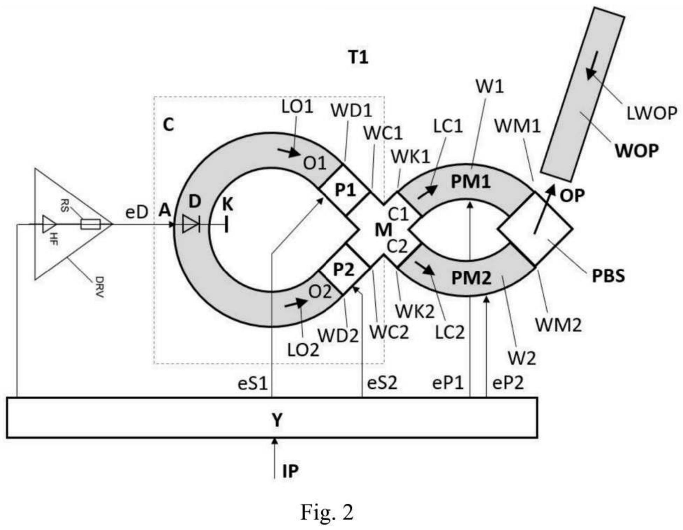

Fig. 2 zeigt schematisch eine erste Ausführungsform einer erfindungsgemäßen optoelektronischen Sendevorrichtung T1. Dabei wird eine selbst-referenzierende Lichtquelle D für die Sendevorrichtung T1 eingesetzt. Diese Lichtquelle D beruht auf den vorhergenannten Silizium-Germanium PIN-Dioden D als Photonenquelle, wobei das emittierte Licht in einer Kavität mit sich selbst in einem Mischer M gemischt wird, dh der nach einer Richtung von der PIN-Dioden D abgestrahlte Lichtanteil wird mit dem nach der anderen Richtung abgestrahlten Lichtanteil überlagert und gemischt. Einer dieser beiden Lichtanteile steht dabei als lokale Referenz im Sinn von optischer Leistung und optischer Phase gegenüber dem anderen Lichtanteil zur Verfügung, um eine Mischung durchführen zu können. Durch diese Mischung bzw Überlagerung entstehen am Ausgang des Mischers M zwei Mischprodukte LC1. LC2, die idente Wellenlänge und, durch den Einsatz von Wellenleitem, ebenso idente Polarisation aufweisen. Die beiden Mischprodukten sind bei einem symmetrischen Aufbau der Kavität gleich gewichtet, d.h. sie weisen idente Leistung auf. Aufgrund von Fertigungstoleranzen zu sind die Mischprodukte LC1, LC2 am Ausgang des Mischers ungleich, sodass vor dem Mischer eine Phasenverschiebung vorgenommen wird, um gleiche Ausgangsleistungen bzw ein vorgegebenes Verhältnis von Ausgangsleistungen am Ausgang des Mischers M zu erhalten.

Diese optoelektronische Sendevorrichtung T1 verfügt über eine wellenleitergebundene Silizium-Germanium PIN-Dioden D, die über zwei optischen Ausgänge O1, O2 verfügt und Licht nach beiden Richtungen der optischen Ausgänge hin abgibt. Die PIN-Piode D ist In eine optische Kavität C eingebracht. Dabei handelt es sich um eine annähernd ringförmige Wellenleiter-Struktur, mit der die Lichtanteile, die über die beiden optischen Ausgänge O1, O2 abgegeben werden, dem Mischer M zugeführt werden können.

Zur weiteren Modulation wird zunächst ein optisches Singal mit konstanter Leistung erstellt. Zu diesem Zwecke wird dazu ein elektronisches Signal am Eingang des Treibers DRV der PIN-Diode D in elektrische Strom- und/oder Spannungssignale an der PIN-Piode D umgewandelt, sodass sich abhängig von dem am Eingang eD anliegenden **Signal ein** Stromfluss in Durchlassrichtung der PIN-Piode D ausbildet, sodass die PIN-Piode D daraufhin über ihren optisch aktiven Bereich elektromagnetische Wellen O1, O2 über ihren Wellenleiter-Ausgänge WD1, WD2 abgibt. Als mögliches Ausführungsbeispiel wird dazu durch den Treiber DRV die Spannung an der Anode A der P PIN-Piode D durch Spannungswerte von typischerweise -1 bis -2V angesteuert, während die Kathode K der PIN-Piode D auf Massepotential liegt. Es stellt sich dadurch ein Vorwärtsstrom von typischerweise 0 bis 20 mA ein, welcher eine stetige Zunahme der Leistung des optischen Signals von 0 bis zu etwa 100 pW bewirkt. Betreibt man die PIN-Piode D wie vorstehend dargestellt, gibt diese optische Signale in Ihrem photosensitiven Bereich ab. Dieser ist wellenleitergebunden, sodass das optische Signal über die beiden Wellenleiter-Ausgänge O1, O2 der PIN-Piode D zur Verfügung steht.

Um die Gewichtung der Mischprodukte LC1; LC2 am Ausgang des Mischers M festzulegen, ist im Lichtweg des von der PIN-Diode D erzeugen Lichts bzw in der Kavität C zumindest einen wellenleitergebundenen Phasenschieber P1 vorgesehen, der einen elektrischen Eingang aufweist und gemäß eines angelegten elektrischen Steuersignals eS1 die Phase des Lichtsignals, welches über den optischen Wellenleiterausgang O1 anliegt, in einem Bereich von 0 bis π rad definiert, bevor diese am optischen Ausgang des Phasenschiebers P1 bereitgestellte Lichtemission mit jener im Wellenleiter WC2 durch einen wellenleitergebundenen optischen Mischer M am Ausgang der Kavität überlagert wird. Dieser Mischer M. der im vorliegenden Ausführungsbeispiel vorzugsweise durch einen 50/50 Koppler realisiert wird, besitzt zwei Eingänge WC1 und WC2, die an die beiden Ausgängen der PIN-Diode D ankoppeln, sowie zwei Ausgänge WK1, WK2, die die beiden Teil-Ausgänge der Kavität bilden.

Um das elektrische Steuersignal eS1 des Phasenschiebers P1 in einem praktikablen Bereich zu halten, kann ein zweiter Phasenschieber P2 am zweiten optischen Eingang WC2 des Mischers M in die Kavität C eingebracht werden, dh im Signalweg des Lichts zwischen einem Wellenleiterausgang O2 und dem Mischer angeordnet sein. Dieser zweite Phasenschieber P2 wird analog dem ersten Phasenschieber P1 von einem von einem elektrischen Steuersignal eS2 angesteuert.

Die durch die beiden Phasenschieber Phasenschieber P1, P2 aufgeprägte Phase definiert das Leistungsverhältnis der Mischprodukte am Ausgang des Mischers M. Der Einsatz eines zweiten Phasenschiebers P2 begünstigt dabei die Symmetrie der Kavität, welche für den selbst-referenzierenden Betrieb der Lichtquelle mit den zuvor genannten Eigenschaften der beiden Mischprodukte LC1, LC2 maßgeblich ist.

Die Mischprodukte LC1, LC2 an den Ausgängen C1, C2 der Kavität C bzw des Mischers werden im Weiteren mit Information beaufschlagt, bevor diese wiederum gemäß einem Referenzrahmen mit sich selbst superponiert werden. Vorzugsweise wird die Beaufschlagung mit Information durch die Modulation der Lichtpolarisation erreicht und ein orthogonaler Referenzrahmen bei der Kopplung beider informationsbehafteter Mischprodukte induziert.

Dieser Referenzrahmen ist notwendig, um die in den beiden Wellenleitem W1, W2 beaufschlagte Information superponieren und später dann interpretieren zu können. Da in der Sendevorrichtung T1 die Information im Polarisationszustand des Lichts kodiert wird, muss ein solcher Referenzrahmen für die Lichtpolarisation definiert werden. Diese Definition für die in den beiden Wellenleitem W1, W2 kodierte Lichtpolarisation wird durch den später folgenden polarisierenden Strahlteiler PBS vorgegeben, wie später erläutert.

Zu diesem Zweck wird die optische Phase der beiden Mischprodukte C1, C2 der Kavität unabhängig voneinander durch Phasenmodulatoren PM1, PM2 moduliert. Die Modulation ist dabei durch die zugehörigen elektrischen Steuersignale eP1, eP2 definiert, an welchen ein zu übertragendes Signal anliegt, das von der Sendevorrichtung T1 abzugeben ist. Die beiden phasenmodulierten optischen Signale LM1, LM2, die an den optischen WellenleiterAusgängen der Phasenmodulatoren PM1, PM2 zur Verfügung stehen, werden anschließend den beiden Wellenleiter-Anschlüssen WM1, WM2 eines polarisierenden Strahlteilers PBS zugeführt und in diesem polarisierenden Strahlteiler PBS optisch überlagert.

Die Funktion zur Kombination von Licht als Welle mit transversal elektrischer und transversal magnetischer Mode durch einen polarisierenden Strahlteiler PBS ist aus der Literatur bekannt (siehe z.B. Watanabe et al, 2-D Grating Couplers for Vertical Fiber Coupling in Two Polarizations, PHOTONICS JOURNAL, VOL. 11, NO. 4, Aug. 2019, Artikelnummer 7904709) und kann auf Wellenleiter-Integrationsplattformen z.B. durch zweidimensionale Gitterkoppier realisiert werden. Der polarisierende Strahlteiler PBS wird in der Erfindung speziell dazu verwendet, um den modulierten Mischprodukten einen Referenzrahmen für deren Superposition aufzuzwingen und die dadurch erlangte Superposition als Lichtausgangssignal OP zur Verfügung zu stellen. Dies erfolgt durch die Definition der orthogonalen Polarisationsbasen durch den polarisierenden Strahlteilers PBS, die sich durch die eindeutige Kopplung dieser beiden Basen mit den Ausgängen WM1, WM2 der beiden Phasenmodulatoren PM1, PM2 in den beiden Wellenleitern W1, W2 ergibt. Die Polarisationsbasen des Referenzrahmens sind durch die ausschließliche Führung der transversal elektrischem bzw. transversal magnetischem Lichtwelle durch die beiden Eingänge WM1, WM2 des polarisierenden Strahltellers PBS gegeben. Somit kann durch eine Phasenmodulation der transversal-elektrischen bzw. transversal-magnetischen Lichtwelle, welche durch die beiden Eingänge WM1, WM2 des polarisierenden Strahlteilers PBS geführt werden, unterschiedliche Polarisationszustände gemäß der Superponierung dieser beiden phasenmodulierten Lichtwellen kodiert werden.

Das Lichtausgangssignal OP der Sendevorrichtung T1 wird durch den polarisierenden Strahlteiler PBS bereitgestellt. Die Auskopplung durch den polarisierenden Strahlteiler PBS erfolgt hier typischerweise durch die Funktion eines Gitterkopplers, welcher Lichtsignale einer planaren Wellenleiterebene des Silizium-Trägers vertikal aus dem Silizium- Träger auskoppelt, sodass sich der Übertragungskanal, der etwa durch einen externen Wellenleiter WOP bereitgestellt wird, nicht in derselben planaren Ebene wie die Wellenleiterelemente der Sendevorrichtung T1 befindet. Gemäß des Beugungsgesetzes ergibt sich dabei je nach Wellenlänge des Lichtausgangssignals OP ein Winkel, der leicht von der vertikalen Auskopplung, vorzugsweise 90 Grad zur planaren Ebene, abweicht.

Die informationsbehafteten Mischprodukte LC1, LC2 in den Wellenleitern WM1, WM2 werden gemäß deren Gewichtung superponiert. Beide Mischprodukte LC1, LC2 erfahren aufgrund der vorgesehenen Symmetrie des Schaltkreises dieselbe Laufzeit entlang der Verschaltung an Wellenleiterkomponenten WK1/WK2, PM1/PM2 sowie WM1/WM2. Daher ergibt sich durch den relativen Phasenhub, der über PM1 und PM2 eingebracht wird, ein durch diese Phasenmodulation definierter eindeutiger Polarisationszustand, der zudem unabhängig von den elektrischen Modulationssignalen eP1, eP2 eine konstante Lichtamplitude aufweist. So können z.B. bei gleicher Gewichtung der Mischprodukte LC1, LC2 durch geeignete Ansteuerung der Phasenmodulatoren PM1, PM2 mit dem zu übertragenden Signal eP1, eP2 insbesondere die vier Polarisationszustände Diagonal, Antidiagonal, Rechts- und Linkszirkular generiert werden, wie sie auf der Poincaré Sphäre zu liegen kommen. In diesem speziellen Fall wäre lediglich eine Ansteuerung des elektrischen Eingangs eP1 des Phasenmodulators PM1 notwendig, da sich diese Zustände durch eine relative Phase zwischen den leistungsbalancierten horizontalen und vertikalen Polarisationszuständen ergeben.

Alternativ kann eine gemeinsame Ansteuerung von des ersten Phasenschiebers P1 und des Phasenmodulators PM1 durch die elektrischen Signale eS1 und eP1 zusätzlich die Polarisationszustände Horizontal und Vertikal in das vorhergenannte Ensemble der Zustände einbringen. Durch die Ansteuerung der Phasenschieber P1, P2 und der Phasenmodulatoren PM1, PM2 lässt sich gemäß der Gewichtung der Mischprodukte C1, C2 und dem relativen Phasenhub innerhalb des Referenzrahmens jeder superponierte Polarisationszustand des Lichtausgangssignals OP erzwingen.

Das Lichtsusgangssignal OP ist das optische Ausgangssignal der Sendevorrichtung T1. Dieses Lichtausgangssignal OP wird in der Regel in eine optische Glasfaser WOP münden, alternativ kann das Lichtausgangssignal OP aber ebenso in optischen Freiraumanwendungen benutzt werden, wo der optische Ausgang einen optischen Funkkanal speist.

Sämtliche verwendete Elemente des Schaltkreises können in deren Funktion auf Silizium-Integrationsplattformen realisiert werden, wodurch sich ein monolithisch integrierter Schaltkreis mit interner Lichtquelle ergibt. Während die gemeinsame Verwendung von III-V Lichtemittern, z.B. InP, InGaAs, einen enormen Aufwand in Bezug auf Hetero-Integration sowie auch in Bezug auf Assembly und Packaging erfordert, kann im vorliegenden Ausführungsbeispiel eine monolithisch integrierte Komponente auf Silizium-Basis verwendet werden. Dies bringt den Vorteil mit sich, dass weniger Interfaces zwischen mehreren Chips erforderlich sind und auch das Alignment zwischen optischen Wellenleitem unterschiedlicher Chips entfallen kann.

Obwohl sich der optische Leistungspegel am Ausgang OP, der wesentlich durch die emittierte Leistung der wellenleitergekoppelten Silizium-Germanium PIN-Diode D bestimmt ist, stark von üblichen Leistungspegeln für die Übertragung von Datensignalen (typischerweise im Milliwatt-Bereich) unterscheidet, ist die beschriebene Ausführungsform vor allem dann vorteilhaft, wenn eine Auslagerung von Komplexität bei den beteiligten Sende-Subsystemen in einem optischen Übertragungskanal aus Kostengründen bevorzugt ist. So kann zum Beispiel die Lichtquelle durch einen Silizium-basierten Sender wesentlich kostengünstiger gestaltet werden, sodass diese Kostenreduktion den Einsatz von optischen Sendeeinheiten in kosten-sensitiven Anwendungen ermöglicht werden. In derartigen Anwendungsszenarien stehen viele kostengünstige Transceiver nahe dem Endnutzer, u.a. auch Maschinen, in baum- oder sternförmig ausgeprägten Netzwerken wenigen zentralisierten Empfangseinheiten am anderen Kanalende gegenüber. Für diese zentralisierten Einheiten kann dann ein komplexerer Empfänger mit weitaus höherer Empfindlichkeit aufgrund eines Kosten-Sharings zwischen vielen Endnutzern gerechtfertigt werden. Solche Empfänger mit erhöhter Empfindlichkeit sind etwa Einzelphotonen-Detektoren oder Empfänger basierend auf Photomultiplier-Effekten.

Der Vorwärtsstrom der PIN-Diode D, der deren Lichtemission bewirkt, muss nicht zwingend konstant sein, sodass die PIN-Diode D zur Abgabe von Licht mit einem vorgegebenen Signalverlauf veranlasst werden kann. Insbesondere kann der Vorwärtsstrom eine gepulste Form sowie mehrere Signalamplituden aufweisen, um Informationssymbole vorzuformen. Für eine schnelle Modulation der Lichtemission kann die Impedanz der Diodenstrecke der PIN-Diode D auch an die Impedanz der Zuleitung und der Treiberschaltung DRV angepasst werden, um maximale Leistungsübertragung zwischen dem elektrischen Treibersignal und der daraus resultierenden optischen Modulation zu gewährleisten. Dies wird in der Regel eine Anpassung der niedrigen Diodenimpedanz an die typischerweise 50-Ohm ausgestalteten Hochfrequenz-Treiberstufen HF des Treibers DRV erfordern und kann im einfachsten Fall durch eine Erhöhung der Impedanz durch einen einfachen Serienwiderstand RS erfolgen. Zweckmäßigerweise setzt sich der vom Treiber abgegebene Vorwärtsstrom der PIN-Diode dann aus einem Gleichanteil und einem Wechselanteil zusammen: Der Wechselanteil bestimmt den Hub der Lichtintensität während der Modulation; Der Gleichanteil definiert den Arbeitspunkt, um welchen diese Modulation der Lichtintensität stattfindet.

Die so geformten Lichtpulse werden dann im Zuge der beschriebenen optischen Phasenmodulation durch PM1, PM2 synchron moduliert, d.h. die elektrische Phase der Steuersignale von D sowie eP1, eP2 sind aufeinander abgestimmt, sodass das Maximum der Lichtpulse D mit der zeitlichen Mitte eines Informationssymbols im Signal eP1, eP2 übereinstimmt. Des Weiteren kann die Amplitude des Vorwärtsstroms der PIN-Diode D so gewählt werden, dass sich eine definierte Lichtleistung am Ausgang des Schaltkreises einstellt, wie es etwa für Anwendungen der Quantenkommunikation erforderlich ist. So erfordert z.B. die Quantenschlüsselverteilung eine emittierte Lichtleistung von etwa 0.1 Photonen pro Symbol.

Die Möglichkeit zur Modulation eines arbiträren Polarisationszustands am Ausgang des Schaltkreises durch die Steuersignale für P1/P2 und PM1/PM2, ermöglicht es dem Schaltkreis, jede beliebige zeitliche Abfolge von Polarisationszuständen zu emittieren. Hierfür wird lediglich die Gewichtung der beiden Mischprodukte LC1, LC2 sowie der relative Phasenhub zwischen den Ausgängen der Phasenmodulatoren PM1, PM2 festgelegt. Dies ermöglicht es, trotz einer Transformation der Polarisationszustände entlang eines Übertragungskanals, z.B. einer Glasfaser, genau definierte Polarisationszustände am Eingang eines Empfängers zu bewirken, sodass dieser durch die Analyse der empfangenen Polarisationszustände in festgelegten Polarisationsbasen die durch den Schaltkreis aufgeprägte Information wiedergewinnen kann.

Hierfür ist es von Vorteil, eine vorgegebene Menge von Zuständen (z.B. Horizontal, Vertikal, Rechts- und Linkszirkular), die durch den Schaltkreis emittiert werden können, am Empfänger zu messen und durch die gemessenen Polarisationszustände die Transformation entlang des Übertragungskanals zu bestimmen. Die so gewonnene Information kann dann an den Schaltkreis durch einen geeigneten Kanal übermittelt werden. Dieser Kanal zur Übermittlung dieser Transformations-Daten muss nicht derselbe sein, der für die Übermittlung der optischen Polarisationszustände benutzt wurde und muss ebenso nicht denselben Medientyp benutzen, d.h. es kann z.B. ein Funkkanal zusätzlich zum optischen Kanal benutzt werden. Anhand der Information über die Transformation entlang des Übertragungskanals kann der Schaltkreis die Polarisationszustände durch eine inverse Transformation so einstellen, dass diese mit der inversen Transformation beaufschlagten emittierten Polarisationszustände in den ursprünglich gewünschten Polarisationszuständen am Empfänger eintreffen - trotz unveränderter Transformation entlang des Übertragungskanals. Ein solches Vorgehen ist vorteilhaft, um eine komplexe Kompensation dieser Transformation durch speziell dafür in der Sende- oder Empfangsvorrichtung eingebrachte elektro-optische Aktuatoren durch funktionelle Integration deren Funktion im emittierenden Schaltkreis zu vermeiden.

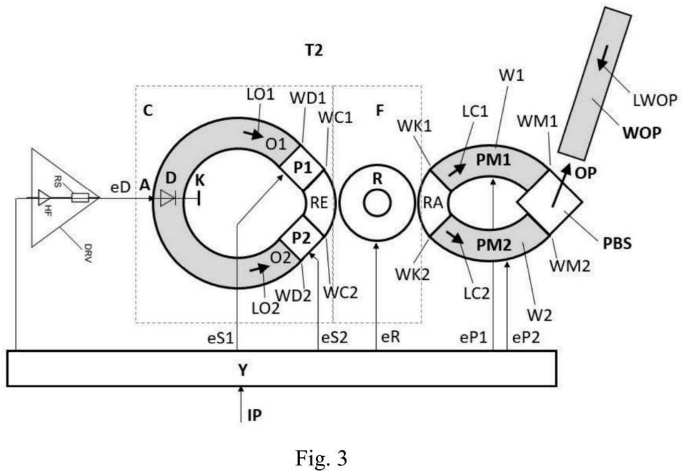

**Fig. 3** zeigt einen emittierenden Schaltkreis mit einer Sendevorrichtung T2 entsprechend einer zweiten Ausführungsform der Erfindung. Diese optoelektronische Sendevorrichtung T2 besitzt wie die in **Fig. 2** dargestellte Sendevorrichtung T1 eine Kavität sowie Phasenmodulatoren PM1, PM2 zum Zweck der Polarisationsmodulation, sowie den polarisierenden Strahlteiler PBS am Ausgang des Schaltkreises. Anders als bei der Sendevorrichtung T1 aus **Fig. 2** kann die in **Fig. 3** dargestellte optoelektronische Sendevorrichtung T2 über eine zusätzliche Filterfunktion am Ausgang der Kavität die optische Bandbreite des optischen Ausgangssignals des Schaltkreises T2 festlegen.

Anstelle eines optischen Mischers M wird bei dieser Ausführungsform ein Resonator R verwendet, der in der Ausführungsform als Ringresonator ausgeführt ist. Ringresonatoren sind aus der Literatur bekannt. Sie sind evaneszent an Wellenleiter eines Schaltkreises gekoppelt und übertragen nur spezifische eingangsseitige Spektralkomponenten eines Lichtsignals an deren Ausgang, wie beispielsweise in Bogaerts et al, Silicon microring resonators, LASER & PHOTONICS REVIEWS, VOL. 6, NO. 1, 2012, Seiten 47-73 näher beschrieben. Dieser Resonator R ist so dimensioniert, dass die Filterfunktion eine gewünschte Transmissions-Bandbreite (z.B. von 1 nm) aufweist, bei gleichzeitiger Unterdrückung von spektralen Emissionskomponenten der PIN-Diode D in einem möglichst weiten Spektralbereich außerhalb dieser Transmissions-Bandbreite. Dies wird durch eine geeignete Wahl einer möglichst hohen Free Spectral Range (z.B. >40 nm) als Charakteristik zur Periodizität des Resonators R erreicht. Der Resonator R kann zusätzlich als verstimmbares Element ausgeführt werden, indem durch eine geeignete elektrooptische Ausführung erreicht wird, dass die optische Länge des Resonators R und somit die Mitten-Wellenlänge der Transmission verändert wird. Dies kann durch elektronische Ansteuerung eR, etwa mittels einer strominduzierten Heizung des Wellenleiters des Resonators oder durch Ladungsträgerinjektion in einen elektrooptisch aktiven Wellenleiter erreicht werden, wie in der Literatur zu Ringresonatoren bekannt.

Bei allen dargestellten Ausführungsbeispielen ist es möglich, dass das zu erzeugende optische Signal durch elektrische Signale eS1, eS2, eP1, eP2 festgelegt wird, das über einen elektronischen Dateneingang IP des Apparats an die elektrische Steuereinheit Y weitergeleitet wird. Alternativ ist es aber auch möglich, dass die Steuereinheit Y ein Signal selbst nach einem vorgegebenen Muster erzeugt oder ein Zufallssignal erzeugt. Dieses der Erzeugung des optischen Signals zugrunde liegende und von der Steuereinheit Y erzeugte elektrische Signal kann, sofern es für weitere Zwecke benötigt wird, auch an einem elektrischen Ausgang des Apparats zur Verfügung gehalten werden.

Die Sendevorrichtungen T1, T2 können sowohl für optische Freiraumkommunikation als auch für fasergebundene Kommunikation verwendet werden. In beiden Fällen wird das Lichtsignal, welches über den Ausgang OP des polarisierenden Strahlteilers PBS bereitgestellt wird, in einen Übertragungskanal gekoppelt. Um eine gute Transmission zu gewährleisten, ist im Allgemeinen eine Ausrichtung der Sendevorrichtung T1, T2 bzw. des Mediums des Übertragungskanals erforderlich, welches durch einen äquivalenten Wellenleiter WOP beschrieben werden kann.

Eine solche Ausrichtung kann begünstigt werden, indem die Sendevorrichtung T1, T2 als Monitor für die Qualität der optischen Kopplung zwischen deren Ausgang OP und dem Wellenleiter WOP verwendet wird. Diese Funktion kann dadurch erreicht werden, dass über den Wellenleiter WOP bzw. Übertragungskanal ein Lichtsignal LWOP in entgegengesetzter Richtung an die Sendevorrichtung T1, T2 übertragen wird und in den Ausgang OP eingekoppelt wird. Diese Lichtkopplung bewirkt nach Transmission des Lichtsignals LWOP entlang aller konstituierender Elemente der Sendevorrichtung T1, T2 ein optisches Eingangssignal an zumindest einem der Wellenleiteranschlüsse der Silizium-Germanium PIN-Diode D, wodurch In dieser ein Photostrom hervorgerufen wird und an deren Anschluss eD gemessen werden kann.

Dieser Photostrom ist abhängig von der relativen Position des Wellenleiters WOP oder des übertragenen Lichts zum Ausgang OP der Sendevorrichtung T1, T2. Eine Maximierung des Photostroms durch iterative Veränderung der lateralen und vertikalen Position des Wellenleiters WOP zum Ausgang OP kann dazu verwendet werden, um eine optimale Kopplung des Wellenleiters WOP zum Ausgang OP der Sendevorrichtung T1, T2 zu erreichen.

Im praktischen Anwendungsfall wird hier zB ein Lichtsignal LWOP mit einer Leistung von - 10 dBm bis 0 dBm und eine optische Frequenz, die auf die spektrale Charakteristik des polarisierenden Strahlteilers PBS abgestimmt ist, verwendet werden. Übliche optische Verluste entlang der Elemente der Sendevorrichtung T1, T2 bewirken einen Photostrom am elektrischen Anschluss eD der PIN-Diode D, welcher sich vom Dunkelstrom der PIN-Diode D abhebt und somit ausreichend Information über die optische Kopplung zwischen Wellenleiters WOP und dem Ausgang OP bereitstellt.

Im Fall der Sendevorrichtung T2, welche einen Ringresonator R als optischen Mischer verwendet, wird die optische Frequenz des Lichtsignals LWOP zweckmäßigerweise auf eine Resonanzfrequenz des Ringresonators R abgestimmt, um den Photostrom, der durch die SiGe PIN-Diode D hervorgerufen wird, zu maximieren und somit das Signal-RauschVerhältnis für die Messung der Koppeleffizienz zu maximieren.

## Patentansprüche

1. Optoelektronische Sendevorrichtung (T1; T2) umfassend einen Wellenleiter (C), in dem eine Licht emittierende, insbesondere Sillzium-Germanium, PIN-Diode (D) angeordnet ist, die dazu ausgebildet ist, Licht nach beiden Richtungen des Wellenleiters (C), dh in einen ersten Wellenleiterausgang (O1) und einen zweiten Wellenleiterausgang (O2) abzustrahlen,
wobei eine optische Mischvorrichtung (M; R) vorgesehen ist, die optisch an die beiden Wellenleiterausgänge (O1, O2) des Wellenleiters (C) angekoppelt ist und in der sich das durch diese Wellenleiterausgänge (O1, O2) transportierte Licht (LO1; LO2) überlagert, wobei im Signalweg des Lichts zwischen zumindest einem Wellenleiterausgang (O1, O2) und der optischen Mischvorrichtung (M; R), insbesondere jeweils separat im jeweiligen Signalweg des Lichts zwischen jedem der beiden Wellenleiterausgänge (O1, O2) und der optischen Mischvorrichtung (M; R), ein Phasenschieber (P1; P2) angeordnet ist, der abhängig von einem elektrischen Stellsignal (eS1; eS2) die Phase des durch den jeweiligen Wellenleiterausgang (O1, O2) transportierten Lichts (LO1; LO2) verschiebt,
wobei die Mischvorrichtung (M; R) zwei optische Ausgänge (C1; C2) aufweist, wobei die Intensität des an den optischen Ausgängen (C1, C2) abgestrahlten Lichts (LC1; LC2) jeweils vom Ergebnis der Überlagerung der beiden über die beiden Wellenleiterausgänge (O1, O2) des ersten Wellenleiters (C) zugeführten Lichtanteile (LO1; LO2) abhängt, und wobei eine Steuervorrichtung (Y) vorgesehen ist, die dem ersten oder zweiten Wellenleiterausgang (O1, O2) nachgeordneten Phasenschieber (P1; P2), insbesondere beide den Wellenleiterausgängen (O1, O2) nachgeordneten Phasenschieber (P1; P2), derart ansteuert, dass die jeweiligen Lichtintensitäten des Lichts (LC1; LC2) an den beiden optischen Ausgängen (C1, C2) der Mischvorrichtung (M; R) in einem vorgegebenen Verhältnis eingestellt sind, insbesondere gleich sind,
wobei die beiden optischen Ausgänge (C1, C2) der Mischvorrichtung (M; R) über zwei weitere Wellenleiter (W1; W2) an die beiden Wellenleiter-Anschlüsse (WM1, WM2) eines polarisierenden Strahlteilers (PBS) geführt sind, wobei in den beiden weitere Wellenleitern (W1, W2) jeweils ein elektrisch gesteuerter Phasenmodulator (PM1, PM2) angeordnet ist, der dazu ausgebildet ist, abhängig von dem ihm jeweils zugeführten elektrischen zu übertragenden Eingangssignal (eP1; eP2) die Phasenlage des durch den jeweiligen weitere Wellenleiter (W1, W2) geführten Lichts (LC1. LC2) einzustellen, und
wobei der optische Ausgang (OP) des polarisierenden Strahlteilers (PBS) den Ausgang der Sendevorrichtung bildet.

2. Optische Sendevorrichtung (T1; T2) nach Anspruch 1, integriert in einem Silizium-Träger, wobei der Wellenleiter (C) und die weiteren Wellenleiter (W1, W2) parallel zur Ebene des Silizium-Trägers angeordnet sind und dass die Abstrahlrichtung des polarisierenden Strahlteilers (PBS) im Winkel, insbesondere normal, zur Ebene des Silizium-Trägers steht, und dass die PIN-Diode gegebenenfalls mit dotiertem Silizium gebildet und im Silizium-Träger integriert ist.

3. Optische Sendevorrichtung (T1) nach Anspruch 1 oder 2, wobei die Mischvorrichtung durch einen optischen Koppler (M), insbesondere einen 50/50 Koppler, mit vier optischen Anschlüssen (WC1; WC2: WK1; WK2) ausgebildet ist, an dessen Eingängen (WC1; WC2) die beiden Wellenleiterausgänge (O1, O2) angekoppelt sind und an dessen optischen Ausgängen (WK1; WK2) die beiden Wellenleiter (W1, W2) angeschlossen sind.

4. Optische Sendevorrichtung (T2) nach Anspruch 1 oder 2, wobei die Mischvorrichtung durch einen Ringresonator (R) ausgebildet ist, an den die beiden Wellenleiterausgänge (O1, O2) über den Einkoppelwellenleiter (RE) des Ringresonators (R) angekoppelt sind, wobei die beiden Wellenleiterausgänge (O1, O2) aus demselben Wellenleiter (C) gebildet sind und dieser Wellenleiter (C) eine Ringschleife ausbildet und ein Teil dieser Ringschleife den Einkoppelwellenleiter (RE) des Ringresonators (R) bildet,
und an den die beiden weiteren Wellenleiter (W1, W2) über den Auskoppelwellenleiter (RA) des Ringresonators (R) angekoppelt sind und den Ausgang der Mischvorrichtung bilden.

5. Optische Sendevorrichtung (T2) nach einem der vorangehenden Ansprüche, wobei die PIN-Diode (D) einen aktiven lichterzeugenden Wellenleiterabschnitt umfasst, an den nach zumindest einer Seite, insbesondere nach beiden Seiten, zum jeweiligen Wellenleiterausgang (O1, O2) hin, ein passiver Wellenleiterabschnitt anschließt, der eine Filterwirkung derart aufweist, dass der passive Wellenleiterabschnitt vorzugsweise nur für Licht innerhalb eines vorgegebenen Frequenzbands durchlässig ist.

6. Optoelektronische Sendevorrichtung (T1; T2) nach einem der vorangehenden Ansprüche, **dadurch gekennzeichnet, dass** im Lichtweg, Insbesondere im Wellenleiter (C) der Kavität, im Mischer (M) oder in den weiteren Wellenleitern (W1, W2) jeweils Filterelemente vorgesehen sind, die dazu ausgebildet sind, einzelne Anteile des Lichts herauszufiltern.

7. Optische Sendevorrichtung (T2) nach einem der Ansprüche 4 bis 6. wobei der Resonator (R) und/oder der passive Wellenleiterabschnitt auf die PIN-Diode (D) derart abgestimmt ist, dass dieser für Frequenzanteile das von der PIN-Diode (D) erstellten Lichts durchlässig ist.

8. Optoelektronische Sendevorrichtung (T1; T2) nach einem der vorangehenden Ansprüche, **dadurch gekennzeichnet, dass** die elektrische Steuereinheit (Y) dazu ausgebildet ist,
a) einen zu übertragenden Datenstrom an einem Eingang zu erhalten und nach vorgegebenen Kriterien zu transformieren, oder mittels eines Zufallsgenerators einen zu übertragenden Datenstrom zu erstellen und
b) basierend auf diesem Datenstrom ein zu übertragendes Eingangssignal (eP1; eP2) für die Phasenmodulatoren (PM1, PM2) bereitzuhalten.

9. Optoelektronische Sendevorrichtung (T1; T2) nach einem der vorangehenden Ansprüche, **dadurch gekennzeichnet, dass** die Steuereinheit (Y) dazu ausgebildet ist, die PIN-Diode (D) mit einem durch den zu übertragenden Datenstrom festgelegten oder vom zu übertragenden Datenstrom vorgegebenen Steuersignal (eD) anzusteuern, insbesondere derart, dass das Steuersignal (eD) sowie die zu übertragenden elektrischen Eingangssignal (eP1, eP2) derart aufeinander abgestimmt sind, dass das Maximum der von der PIN-Diode (D) abgegebenen Lichtpulse mit der zeitlichen Mitte eines Informationssymbols im Eingangssignal (eP1, eP2) zeitlich übereinstimmt.

10. Verfahren zur Ankopplung einer optischen Sendevorrichtung (T1; T2) an einen Empfänger zum Empfang der vom optischen Ausgang (OP) ausgehenden Lichtsignale oder an einen Ausgangs-Wellenleiter (WOP) an den optischen Ausgang (OP), die mittels einer PIN-Diode (D) erzeugtes Licht an ihrem Ausgang bereithält, der durch den optischen Ausgang (OP) eines polarisierenden Strahlteilers (PBS) ausgebildet ist, wobei die optische Sendevorrichtung (T1; T2) vorzugsweise nach einem der vorangehenden Ansprüche ausgebildet ist,
umfassend das iterative Wiederholen der folgenden Schritte:
a) Einstrahlen von Licht, insbesondere Laserlicht, vorzugsweise mit derselben Frequenz wie das von der Sendevorrichtung abgestrahlte Licht, in den optischen Ausgang (OP) der optischen Sendevorrichtung (T1, T2), insbesondere über den Ausgangs-Wellenleiter (WOP),
b) Ermitteln des dadurch an der PIN-Diode (D) bewirkten Photostroms, welcher am elektrischen Anschluss der PIN-Diode (D) bereitgestellt wird, unter Änderung der Relativposition und/oder -ausrichtung des Ausgangs-Wellenleiters (WOP) oder des Empfängers relativ zum polarisierenden Strahlteiler (PBS), insbesondere des lateralen und vertikalen Abstands des Ausgangs-Wellenleiters (WOP) des polarisierenden Strahlteiler (PBS) zum Ausgangs-Wellenleiter (WOP), und dahingehend, dass sich der in Schritt b) ermittelte Photostrom erhöht oder dass dieser Photostrom maximiert wird.
